# EUROPÄISCHE PATENTSCHRIFT

(11) **EP 4 275 228 B1**
(45) Veröffentlichungstag und Bekanntmachung des Hinweises auf die Patenterteilung: **02.04.2025**
(21) Anmeldenummer: 22711885.8
(22) Anmeldetag: 21.02.2022
(51) Int. Cl.: H01L 23/427, H01L 21/48, H01L 23/373

(54) **HALBLEITERMODULANORDNUNG MIT EINEM KÜHLKÖRPER UND ZUMINDEST EINEM HALBLEITERMODUL**
SEMICONDUCTOR MODULE ASSEMBLY COMPRISING A HEAT SINK AND AT LEAST ONE SEMICONDUCTOR MODULE
AGENCEMENT DE MODULE SEMI-CONDUCTEUR DOTÉ D'UN DISSIPATEUR THERMIQUE ET D'AU MOINS UN MODULE SEMI-CONDUCTEUR

(30) Priorität: 08.04.2021 EP 21167429
(43) Veröffentlichungstag der Anmeldung: 15.11.2023
(73) Patentinhaber: Siemens Aktiengesellschaft, 80333 München (DE)
(72) Erfinder: SCHWARZ, Florian, 90766 Fürth (DE)
(74) Vertreter: Siemens Patent Attorneys
(86) Internationale Anmeldenummer: PCT/EP2022/054223
(87) Internationale Veröffentlichungsnummer: WO 2022/214231

(56) Entgegenhaltungen:
- EP-A1- 3 336 471
- DE-A1- 102010 041 714
- DE-A1- 102018 206 020
- JP-A- 2002 289 995
- US-A1- 2002 185 726

## Beschreibung

Die Erfindung betrifft eine Halbleitermodulanordnung mit einem Kühlkörper und zumindest einem Halbleitermodul.

Die Erfindung betrifft darüber hinaus einen Stromrichter mit mindestens einer derartigen Halbleitermodulanordnung.

Derartige Halbleitermodulanordnungen kommen in der Regel in einem Stromrichter zum Einsatz. Unter einem Stromrichter ist beispielsweise ein Gleichrichter, ein Wechselrichter, ein Umrichter oder ein Gleichspannungswandler zu verstehen.

Mit der fortschreitenden Miniaturisierung in der Aufbau- und Verbindungstechnik, beispielsweise durch eine planare Aufbau- und Verbindungstechnik, nimmt die Leistungsdichte in Halbleitermodulen zu. Um Elektronikausfälle durch thermische Überlastungen zu vermeiden, werden daher immer effektivere aber auch kostengünstigere Konzepte zum Entwärmen von Halbleiterelementen benötigt.

Die Patentschrift DE 10 2013 207 804 B4 beschreibt ein Leistungsmodul aufweisend ein Substrat mit einem elektrisch isolierenden Element mit einer ersten metallbeschichteten Seite und einer gegenüberliegenden zweiten metallbeschichteten Seite und einem oder mehreren Halbleiterchips, die an der ersten metallbeschichteten Seite des Substrats befestigt sind. Eine Vielzahl wärmeleitender Strukturen ist seitlich voneinander beabstandet und einzeln direkt an der zweiten metallisierten Seite des Substrats befestigt, so dass die Vielzahl wärmeleitender Strukturen von der zweiten metallisierten Seite nach außen ragt.

Die Patentschrift US 10,665,525 B2 beschreibt eine Vorrichtung mit einem Modul, das einen Halbleiterchip einschließt.

Die Vorrichtung kann einen Kühlkörper einschließen, der mit dem Modul gekoppelt ist und ein Substrat und eine Vielzahl von Vorsprüngen einschließt. Die Vorrichtung kann eine Abdeckung einschließen, die einen Kanal einschließt, wobei die Vielzahl von Vorsprüngen des Kühlkörpers innerhalb des Kanals angeordnet ist, und kann einen Dichtungsmechanismus einschließen, der zwischen der Abdeckung und dem Modul angeordnet ist.

Die Offenlegungsschrift DE 10 2018 206 020 A1 beschreibt eine Anordnung mit einer Schaltungsträgerplatte, auf der mindestens ein elektrisches/elektronisches Bauelement angeordnet ist. In der Schaltungsträgerplatte ist mindestens ein Wärmerohr ausgebildet.

Die Offenlegungsschriften EP 3 336 471 A1 (ICOFLEX SARL; Veröffentlichungsdatum: 20. Juni 2018), US 2002/185726 A1 (NORTH MARK T ET AL) Veröffentlichungsdatum: 12. Dezember 2002) und JP 2002 289995 A (FUJI ELECTRIC CO LTD) Veröffentlichungsdatum: 4. Oktober 2002) offenbaren jeweils Halbleitermodulanordnungen mit Kühlkörper und Wärmetransportfluid-Kanälen.

Vor diesem Hintergrund liegt der Erfindung die Aufgabe zugrunde, eine Halbleitermodulanordnung anzugeben, welche eine, im Vergleich zum Stand der Technik, effektivere Entwärmung und kostengünstigere Herstellung ermöglicht.

Diese Aufgabe wird erfindungsgemäß gelöst durch eine Halbleitermodulanordnung aufweisend einen Kühlkörper und zumindest ein Halbleitermodul, welches auf dem Kühlkörper kontaktiert ist, wobei der Kühlkörper einen Kühlkörpergrundkörper und einen Kühlkörperaufsatz umfasst, wobei der Kühlkörperaufsatz auf einer ersten Oberfläche eine Kanalstruktur aufweist, in welcher ein Wärmetransportfluid angeordnet ist, wobei der Kühlkörpergrundkörper eine Kühlkörpergrundkörperoberfläche aufweist, wobei die Kanalstruktur durch eine stoffschlüssige Verbindung mit der Kühlkörpergrundkörperoberfläche des Kühlkörpergrundkörpers hermetisch verschlossen ist, sodass sowohl der Kühlkörperaufsatz als auch der Kühlkörpergrundkörper in unmittelbarem Kontakt mit dem Wärmetransportfluid stehen, wobei durch die hermetisch verschlossene Kanalstruktur und das Wärmetransportfluid eine pulsierende Heatpipe ausgebildet ist, welche mit dem Halbleitermodul in einer thermisch leitfähigen Verbindung steht.

Ferner wird die Aufgabe erfindungsgemäß gelöst durch eine Halbleitermodulanordnung aufweisend einen Kühlkörper und zumindest ein Halbleitermodul welches auf dem Kühlkörper kontaktiert ist, wobei der Kühlkörper einen Kühlkörpergrundkörper und einen Kühlkörperaufsatz umfasst, wobei der Kühlkörpergrundkörper eine Kühlkörpergrundkörperoberfläche aufweist, wobei auf der Kühlkörpergrundkörperoberfläche eine Kanalstruktur, in welcher ein Wärmetransportfluid angeordnet ist, ausgebildet ist, wobei der Kühlkörperaufsatz eine erste Oberfläche aufweist, wobei die Kanalstruktur durch eine stoffschlüssige Verbindung mit der ersten Oberfläche des Kühlkörperaufsatzes hermetisch verschlossen ist, sodass sowohl der Kühlkörperaufsatz als auch der Kühlkörpergrundkörper in unmittelbarem Kontakt mit dem Wärmetransportfluid stehen, wobei durch die hermetisch verschlossene Kanalstruktur und das Wärmetransportfluid eine pulsierende Heatpipe ausgebildet ist, welche mit dem Halbleitermodul in einer thermisch leitfähigen Verbindung steht.

Darüber hinaus wird die Aufgabe erfindungsgemäß gelöst durch einen Stromrichter mit mindestens einer derartigen Halbleitermodulanordnung.

Die in Bezug auf die Halbleitermodulanordnung nachstehend angeführten Vorteile und bevorzugten Ausgestaltungen lassen sich sinngemäß auf den Stromrichter übertragen.

Der Erfindung liegt die Überlegung zugrunde, zumindest ein Halbleitermodul einer Halbleitermodulanordnung kostengünstig über einen Kühlkörper mit einer pulsierenden Heatpipe zu entwärmen. Eine pulsierende Heatpipe (engl. pulsating heat pipe, PHP), die auch als oszillierende Heatpipe (engl. oscillating heat pipe, OHP) bezeichnet wird, ist eine Vorrichtung zur Wärmeübertragung mit einer geschlossenen Kanalstruktur, in der ein Wärmetransportmedium angeordnet ist, das entlang der Kanalstruktur durch die Oberflächenspannung des Wärmetransportmediums abwechselnd Dampfsegmente und Flüssigsegmente bildet. Diese Dampf- und Flüssigsegmente werden durch einen Temperaturgradienten zum Pulsieren beziehungsweise Oszillieren angeregt. An einer Wärmequelle dehnen sich die Dampfsegmente aufgrund der höheren Temperatur aus; zudem siedet flüssiges Wärmetransportmedium dort und nimmt dabei latente Wärme auf. An einer Wärmesenke schrumpfen die Dampfsegmente durch Kondensation gasförmigen Wärmetransportmediums und geben dabei latente Wärme ab. Die lokalen Temperatur- und Druckunterschiede treiben das ständige Pulsieren beziehungsweise Oszillieren der Dampf- und Flüssigsegmente an.

Eine kostengünstige Realisierung einer derartigen pulsierenden Heatpipe wird erreicht, indem der Kühlkörper einen Kühlkörpergrundkörper und einen Kühlkörperaufsatz umfasst, wobei das zumindest eine Halbleitermodul auf dem Kühlkörper kontaktiert ist. Das Halbleitermodul kann durch Schweißen, Löten, Sintern oder durch mechanisches Angedrücken, z.B. mittels Schrauben, kontaktiert und optional, beispielsweise mittels eines Dichtrings, abgedichtet werden. Auf einer dem zumindest einen Halbleitermodul abgewandten Seite des Kühlkörperaufsatz wird eine Kanalstruktur zur Aufnahme eines Wärmetransportfluids, welches beispielsweise Wasser, Aceton oder Methanol enthält, eingefügt, wobei die Kanalstruktur durch eine stoffschlüssige Verbindung des Kühlkörperaufsatzes mit einer Kühlkörpergrundkörperoberfläche des Kühlkörpergrundkörpers hermetisch verschlossen wird, sodass sowohl der Kühlkörperaufsatz als auch der Kühlkörpergrundkörper in unmittelbarem Kontakt mit dem Wärmetransportfluid stehen. Die stoffschlüssige Verbindung ist beispielsweise mittels Kleben, Löten, Schweißen oder Sintern hergestellt. Ein unmittelbarer Kontakt besteht in diesem Zusammenhang, wenn das Wärmetransportfluid direkt und ohne dazwischen angeordnete Komponenten sowohl mit dem Kühlkörperaufsatz als auch mit dem Kühlkörpergrundkörper in Kontakt steht. Durch die hermetisch verschlossene Kanalstruktur, welche das Wärmetransportfluid enthält, ist eine pulsierende Heatpipe ausgebildet, welche mit dem Halbleitermodul in einer thermisch leitfähigen Verbindung steht.

Alternativ ist die Kanalstruktur zur Aufnahme des Wärmetransportfluids auf der Kühlkörpergrundkörperoberfläche des Kühlkörpergrundkörpers ausgebildet, wobei die Kanalstruktur durch eine stoffschlüssige Verbindung der Kühlkörpergrundkörperoberfläche des Kühlkörpergrundkörpers mit dem Kühlkörperaufsatz hermetisch verschlossen wird, sodass sowohl der Kühlkörperaufsatz als auch der Kühlkörpergrundkörper in unmittelbarem Kontakt mit dem Wärmetransportfluid stehen.

Eine derartige Halbleitermodulanordnung ermöglicht die Verwendung eines, beispielsweise stranggepressten, Standard-Kühlkörpers als Kühlkörpergrundkörper, sodass eine gute Kostenposition erreicht wird. Der Kühlkörperaufsatz ist beispielsweise mittels Druckguss kostengünstig herstellbar. Es ist keine pulsierende Heatpipe als dediziertes zusätzliches Bauteil erforderlich. Das Befüllen der pulsierenden Heatpipe mit dem Wärmetransportfluid kann nach einem Standardprozess erfolgen. Ferner wird durch die pulsierende Heatpipe eine effektive Entwärmung durch Wärmespreizung erreicht, sodass beispielsweise keine Kupferbodenplatte für das zumindest eine Halbleitermodul erforderlich ist.

Der Kühlkörperaufsatz weist ein Mittelstück und beidseitig angeordnete Endstücke auf, wobei das Mittelstück im Wesentlichen parallel angeordnete Kanäle der Kanalstruktur umfasst und wobei die beidseitig angeordneten Endstücke jeweils Umlenkkanäle der Kanalstruktur aufweisen, wobei die Umlenkkanäle derartig angeordnet sind, dass diese eine fluidtechnischen Verbindung zwischen den im Wesentlichen parallel angeordneten Kanälen des Mittelstücks herstellen. Die Umlenkkanäle sind beispielsweise als Nuten ausgeführt. Insbesondere sind die Endstücke jeweils stoffschlüssig mit dem Mittelstück verbunden. Beispielsweise ist die stoffschlüssige Verbindung zwischen dem jeweiligen Eckstück und dem Mittelstück hermetisch dicht ausgeführt, um ein Entweichen des Wärmetransportfluids zu verhindern. Das Mittelstück und die Endstücke des Kühlkörperaufsatzes sind beispielsweise aus einem metallischen Werkstoff, insbesondere aus Aluminium oder einer Aluminiumlegierung, hergestellt. Durch die parallel angeordneten Kanäle der Kanalstruktur ist das Mittelstück, beispielsweise durch Strangpressen, einfach und kostengünstig herstellbar.

Eine weitere Ausführungsform sieht vor, dass der Kühlkörpergrundkörper auf einer dem Kühlkörperaufsatz abgewandten Seite eine Mehrzahl von Kühlfinnen aufweist, wobei die im Wesentlichen parallel angeordnete Kanäle des Mittelstücks quer zu den Kühlfinnen verlaufend angeordnet sind. Durch eine derartige orthogonale Anordnung wird eine verbesserte Temperaturverteilung erzielt, sodass eine effektivere Entwärmung erfolgt.

Eine weitere Ausführungsform sieht vor, dass das zumindest eine Halbleitermodul ein Substrat umfasst, welches zumindest ein Halbleiterbauelement und eine auf einer dem Halbleiterbauelement abgewandten Seite angeordnete Metallisierung umfasst, wobei die Metallisierung des Substrats unmittelbar mit dem Kühlkörperaufsatz verbunden ist. Insbesondere können die Metallisierung des Substrats und zumindest ein Teil des Kühlkörperaufsatzes einstückig ausgebildet sein. Unter einer unmittelbaren Verbindung ist in diesem Zusammenhang eine direkte Verbindung zu verstehen, die Verbindungsmittel zur Herstellung der stoffschlüssigen Verbindung wie z.B. Kleber, Lötzinn oder Sinterpaste einschließt, ein zusätzliches Verbindungselement wie z.B. einen Abstandshalter oder eine Bodenplatte jedoch ausschließt. Durch den Wegfall eines derartigen zusätzlichen Verbindungselements wird eine verbesserte thermische Anbindung des Halbleitermoduls erreicht, sodass eine verbesserte Entwärmung stattfindet.

Eine weitere Ausführungsform sieht vor, dass der Kühlkörperaufsatz auf einer zweiten Oberfläche eine Kavität aufweist, in welcher das Halbleitermodul mit dem Kühlkörperaufsatz kontaktiert ist. Die Kavität, welche beispielsweise eine rechteckige Außenkontur aufweist, wird insbesondere durch spanende Verarbeitung, z.B. Fräsen, eingefügt. Durch die Kavität ist das Halbleitermodul näher an der pulsierenden Heatpipe anordenbar, was zu einer verbesserten Entwärmung führt.

Eine weitere Ausführungsform sieht vor, dass die Kavität derartig ausgeführt ist, dass das Halbleitermodul in unmittelbarem Kontakt mit dem Wärmetransportfluid steht. Ein unmittelbarer Kontakt besteht in diesem Zusammenhang, wenn das Wärmetransportfluid direkt und ohne dazwischen angeordnete Komponenten mit Teilen des Halbleitermoduls kontaktiert ist. Beispielsweise ist eine Tiefe der Kavität zumindest so groß gewählt, dass sich die Tiefe der Kavität und eine zweite Tiefe der Kanäle zu einer Gesamtdicke des Kühlkörperaufsatzes addieren. Durch eine derartige unmittelbare Kontaktierung werden die thermischen Kontaktwiderstände reduziert.

Eine weitere Ausführungsform sieht vor, dass zumindest das Mittelstück des Kühlkörperaufsatzes aus Aluminium oder einer Aluminiumlegierung, insbesondere mittels Strangpressen, hergestellt ist. Ein stranggepresster Kühlkörperaufsatz ist, beispielsweise im Vergleich zu einem gegossenen Kühlkörperaufsatz, aus einer Aluminiumlegierung mit einem niedrigeren Siliziumanteil, z.B. 0,5%, herstellbar, sodass eine verbesserte thermische Leitfähigkeit erreicht wird. Ein derartiger aus Aluminium oder einer Aluminiumlegierung hergestellter Kühlkörperaufsatz verbessert die thermische Anbindung des Halbleitermoduls, insbesondere im Vergleich zu einem Kühlkörperaufsatz aus Kunststoff.

Eine weitere Ausführungsform sieht vor, dass der Kühlkörperaufsatz aus einem dielektrischen Werkstoff hergestellt ist, welcher, insbesondere vollständig, mit einem metallischen Werkstoff beschichtet ist, wobei das Halbleitermodul durch Löten mit dem Kühlkörperaufsatz verbunden ist. Ein dielektrischer Werkstoff ist beispielsweise ein keramischer Werkstoff oder ein Kunststoff. Der Kühlkörperaufsatz aus Kunststoff ist leicht und, beispielsweise durch Gießen, kostengünstig herstellbar. Eine, insbesondere vollständige, Beschichtung mit einem metallischen Werkstoff, z.B. Kupfer, kann kostengünstig und zuverlässig durch Galvanisieren, thermische Spritzverfahren oder, insbesondere chemische oder physikalische, Gasphasenabscheidung erfolgen. Beispielsweise wird durch die metallische Beschichtung eine verbesserte Gasdichtigkeit erreicht. Eine weitere Ausführungsform sieht vor, dass der Kühlkörperaufsatz aus einem dielektrischen Werkstoff hergestellt ist, wobei das Halbleitermodul durch Kleben mit dem Kühlkörperaufsatz verbunden ist. Insbesondere fungiert der Kühlkörperaufsatz als Isolator. Ein dielektrischer Werkstoff ist beispielsweise ein keramischer Werkstoff oder ein Kunststoff. Ein aus einem Kunststoff hergestellter Kühlkörperaufsatz ist leicht und, beispielsweise durch Gießen, insbesondere Spritzguss, kostengünstig herstellbar. Ein aus einem keramischen Werkstoff hergestellter Kühlkörperaufsatz weist nahezu optimale Isolationseigenschaften und eine gute Wärmeleitfähigkeit auf.

Eine weitere Ausführungsform sieht vor, dass das zumindest eine Halbleiterbauelement des Halbleitermoduls unmittelbar auf einer Metallisierung kontaktiert ist, wobei der dielektrische Werkstoff elektrisch isolierend ausgeführt ist, wobei die Metallisierung des Halbleitermoduls unmittelbar auf dem aus einem dielektrischen Werkstoff hergestellten Kühlkörperaufsatz aufgeklebt ist. Eine dielektrische Materiallage des Substrats fällt somit weg, sodass durch eine derartige unmittelbare Kontaktierung thermische Kontaktwiderstände reduziert werden.

### Zusammenfassung der Erfindung

Die Erfindung ist im beigefügten Anspruchssatz beschrieben.

Im Folgenden wird die Erfindung anhand der in den Figuren dargestellten Ausführungsbeispiele näher beschrieben und erläutert.

Es zeigen:
- FIG 1: eine schematische dreidimensionale Darstellung einer ersten Ausgestaltung einer Halbleitermodulanordnung,
- FIG 2: eine schematische Darstellung einer zweiten Ausgestaltung einer Halbleitermodulanordnung im Querschnitt,
- FIG 3: eine schematische Darstellung der dritten Ausgestaltung der Halbleitermodulanordnung im Längsschnitt,
- FIG 4: eine schematische dreidimensionale Darstellung eines Ausschnitts der ersten Ausgestaltung der Halbleitermodulanordnung,
- FIG 5: eine schematische Darstellung einer vierten Ausgestaltung einer Halbleitermodulanordnung im Querschnitt,
- FIG 6: eine schematische Darstellung der vierten Ausgestaltung der Halbleitermodulanordnung im Längsschnitt,
- FIG 7: eine schematische Darstellung eines Ausschnitts einer fünften Ausgestaltung einer Halbleitermodulanordnung im Querschnitt,
- FIG 8: eine schematische Darstellung eines Ausschnitts einer sechsten Ausgestaltung einer Halbleitermodulanordnung im Querschnitt,
- FIG 9: eine schematische Darstellung einer siebten Ausgestaltung einer Halbleitermodulanordnung im Querschnitt,
- FIG 10: eine schematische Darstellung einer achten Ausgestaltung einer Halbleitermodulanordnung im Querschnitt und
- FIG 11: eine schematische Darstellung eines Stromrichters.

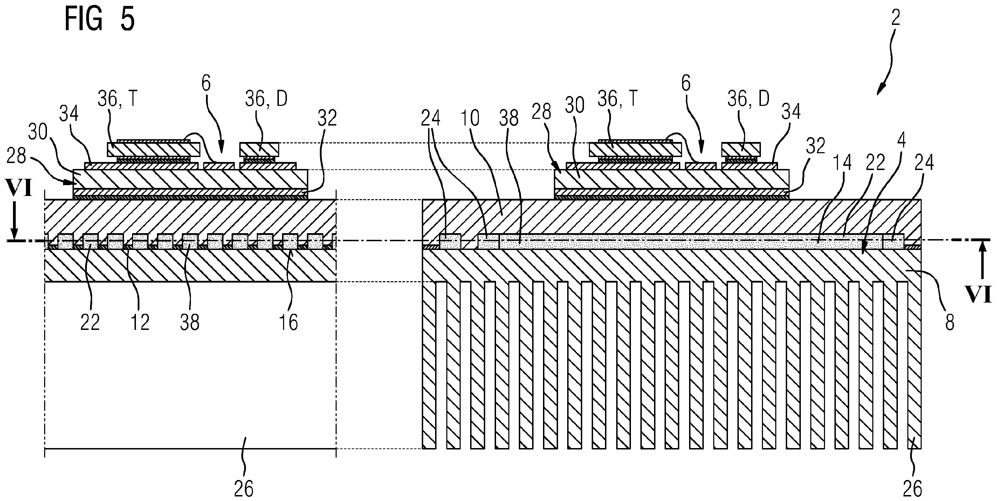

Die Ausführungsbeispiele Figuren 5-8 fallen nicht unter den Wortlaut der Ansprüche, werden aber als das Verständnis der Erfindung erleichternd angesehen.

Gleiche Bezugszeichen haben in den verschiedenen Figuren die gleiche Bedeutung.

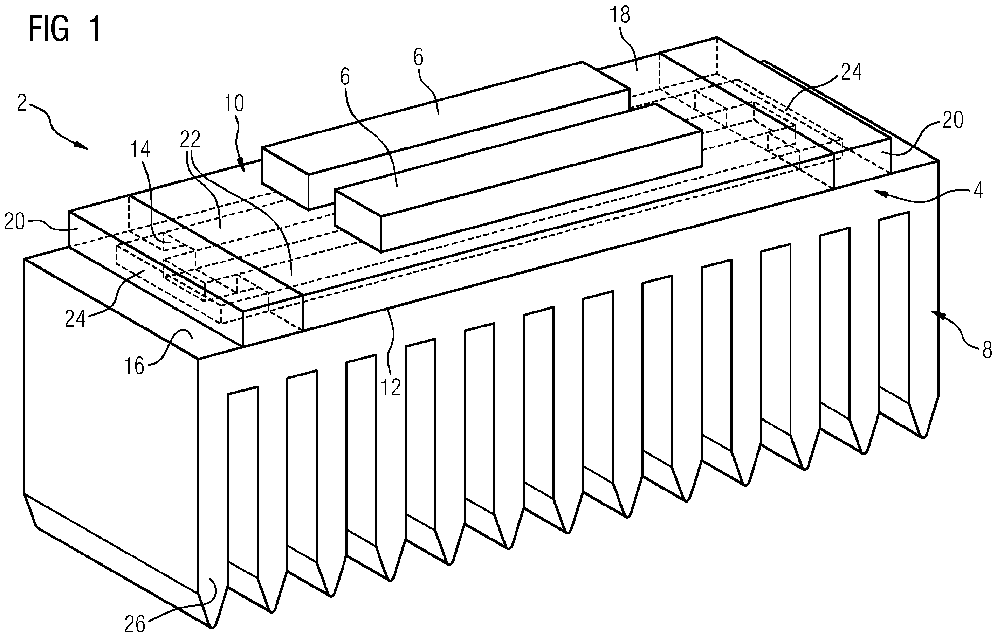

FIG 1 zeigt eine schematische dreidimensionale Darstellung einer ersten Ausgestaltung einer Halbleitermodulanordnung **2.** Die Halbleitermodulanordnung 2 weist einen Kühlkörper 4 und beispielhaft zwei Halbleitermodule 6, welche auf dem Kühlkörper 4 kontaktiert sind, auf. Der Kühlkörper 4 weist einen Kühlkörpergrundkörper 8 und einen Kühlkörperaufsatz 10 auf, wobei der Kühlkörperaufsatz 10 auf einer ersten Oberfläche 12 eine Kanalstruktur 14 aufweist, in welcher ein Wärmetransportfluid, beispielsweise Wasser, Aceton oder Methanol, angeordnet ist. Der Kühlkörpergrundkörper 8 ist beispielsweise aus Aluminium oder einer Aluminiumlegierung mittels Strangpressen hergestellt und weist eine Kühlkörpergrundkörperoberfläche 16 auf. Der Kühlkörperaufsatz 10 ist stoffschlüssig mit der Kühlkörpergrundkörperoberfläche 16 des Kühlkörpergrundkörpers 8 verbunden. Die stoffschlüssige Verbindung ist beispielsweise mittels Kleben, Löten, Schweißen oder Sintern hergestellt. Durch die stoffschlüssige Verbindung ist die Kanalstruktur 14 hermetisch verschlossen, wobei sowohl der Kühlkörperaufsatz 10 als auch der Kühlkörpergrundkörper 8 in unmittelbarem Kontakt mit dem Wärmetransportfluid stehen. Durch die hermetisch verschlossene Kanalstruktur 14 und das Wärmetransportfluid wird eine pulsierende Heatpipe ausgebildet, welche mit den Halbleitermodulen 6 in einer thermisch leitfähigen Verbindung steht.

Der Kühlkörperaufsatz 10 weist ein Mittelstück 18 und zwei beidseitig angeordnete Endstücke 20 auf, welche stoffschlüssig mit dem Mittelstück 18 verbunden sind. Die stoffschlüssige Verbindung zwischen dem jeweiligen Eckstück 20 und dem Mittelstück 18 ist hermetisch dicht, um ein Entweichen des Wärmetransportfluids zu verhindern. Das Mittelstück 18 und die Endstücke 20 des Kühlkörperaufsatzes 10 sind beispielsweise aus einem metallischen Werkstoff, insbesondere aus Aluminium oder einer Aluminiumlegierung, hergestellt. Das Mittelstück 18 umfasst im Wesentlichen parallel angeordnete Kanäle 22 der Kanalstruktur 14, sodass das Mittelteil mittels Strangpressen herstellbar ist. Die beidseitig angeordneten Endstücke 20 umfassen Umlenkkanäle 24 der Kanalstruktur 14, wobei die Umlenkkanäle 24 die im Wesentlichen parallel angeordneten Kanäle 22 des Mittelstücks 18 verbinden und so eine fluidtechnischen Verbindung zwischen den im Wesentlichen parallel angeordneten Kanälen 22 herstellen. Die Umlenkkanäle 24 sind beispielsweise als Nuten in den Endstücken 20 ausgeführt.

Der Kühlkörpergrundkörper 8 weist auf einer dem Kühlkörperaufsatz 10 abgewandten Seite eine Mehrzahl von Kühlfinnen 26 auf, wobei die im Wesentlichen parallel angeordnete Kanäle 22 des Mittelstücks 18 quer zu den Kühlfinnen 26 verlaufend angeordnet sind.

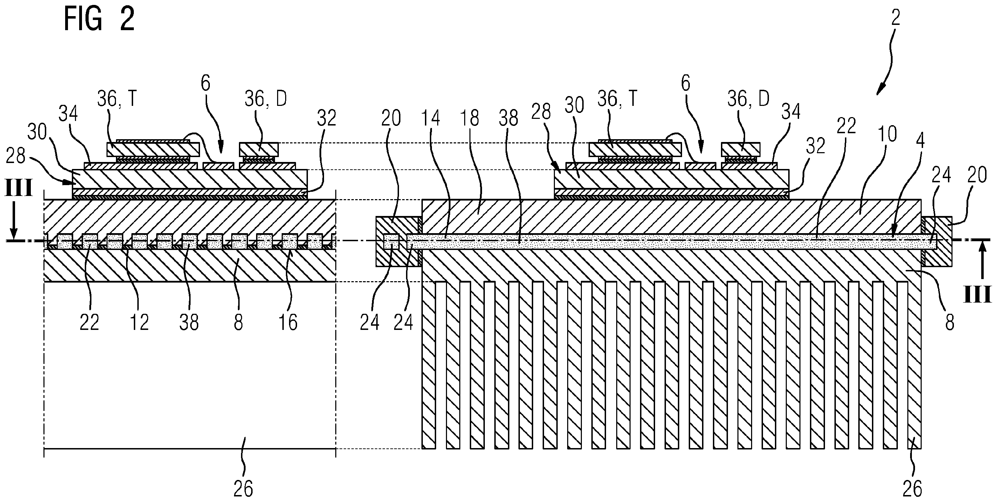

FIG 2 zeigt eine schematische Darstellung einer zweiten Ausgestaltung einer Halbleitermodulanordnung 2 im Querschnitt, wobei das beispielhaft eine Halbleitermodul 6 ein Substrat 28 umfasst. Das Substrat 28 weist eine dielektrische Materiallage 30 mit einer Stärke von 25 µm bis 400 µm, insbesondere 50 µm bis 250 µm, auf, die einen keramischen Werkstoff, beispielsweise Aluminiumnitrid oder Aluminiumoxid, oder einen organischen Werkstoff, beispielsweise einem Polyamid enthält. Darüber hinaus weist das Substrat 28 eine auf einer den Halbleiterbauelementen 30 abgewandten Seite angeordnete Metallisierung 32 auf, die beispielsweise Kupfer enthält. Insbesondere können die Metallisierung 32 des Substrats 28 und zumindest ein Teil des Kühlkörperaufsatzes 10, **z.B.** das Mittelstück 18, einstückig ausgebildet sein. Auf einer Kupferkaschierung 34 des Substrats 28 sind Halbleiterbauelemente 36 kontaktiert. Die Halbleiterelemente 6 umfassen exemplarisch einen Transistor T, welcher insbesondere als Insulated-Gate-Bipolar-Transistor (IGBT) ausgeführt ist, und eine antiparallel zum Transistor T geschaltete Diode **D.** Der Transistor T kann alternativ als Metalloxide-Semiconductor-Field-Effect-Transistor (MOSFET) oder als Bipolartransistor ausgeführt sein. Zusätzlich oder alternativ umfassen die Halbleiterelemente 6 einen digitalen Logikbaustein, insbesondere einen Field Programmable Gate Array (FPGA), oder einen anderen Halbleiter. Insbesondere weist der Transistor T eine Fläche von mindestens 10 mm² auf. Über die Metallisierung 32 ist das Substrat 28 unmittelbar stoffschlüssig mit dem Kühlkörperaufsatz 10 verbunden. Unter einer unmittelbar stoffschlüssigen Verbindung ist eine direkte Verbindung zu verstehen, die Verbindungsmittel zur Herstellung der stoffschlüssigen Verbindung wie Kleber, Lötzinn, Sinterpaste, ... einschließt, ein zusätzliches Verbindungselement wie einen zusätzlichen Leiter, einen Bonddraht, einen Abstandshalter, eine Bodenplatte, ... jedoch ausschließt.

Durch die hermetisch verschlossene Kanalstruktur 14 und das Wärmetransportfluid 38 wird eine pulsierende Heatpipe ausgebildet, welche mit dem Halbleitermodul 6 in einer thermisch leitfähigen Verbindung steht. Die im Wesentlichen parallel angeordnete Kanäle 22 der hermetisch verschlossenen Kanalstruktur 14 weisen einen, insbesondere identischen, rechteckigen oder trapezförmigen Querschnitt auf. Die weitere Ausgestaltung der Halbleitermodulanordnung 2 in FIG 2 entspricht der in FIG 1.

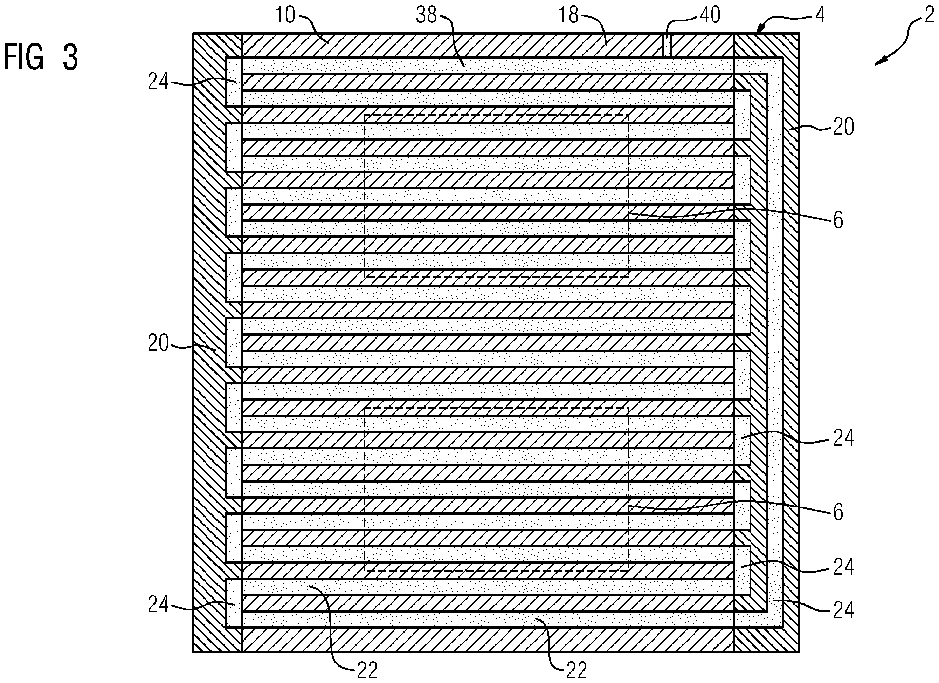

FIG 3 zeigt eine schematische Darstellung der dritten Ausgestaltung der Halbleitermodulanordnung 2 im Längsschnitt. Die Kanalstruktur 14 weist einen mäanderförmigen Teil auf, wobei die Mäanderform durch die im Wesentlichen parallel angeordneten Kanäle 22 und die diese verbindenden Umlenkkanäle 24 ausgebildet wird. Eine verschließbare Öffnung 40 ist für eine Zuführung des Wärmetransportfluids 38 vorgesehen. Die weitere Ausgestaltung der Halbleitermodulanordnung 2 in FIG 3 entspricht der in FIG 2.

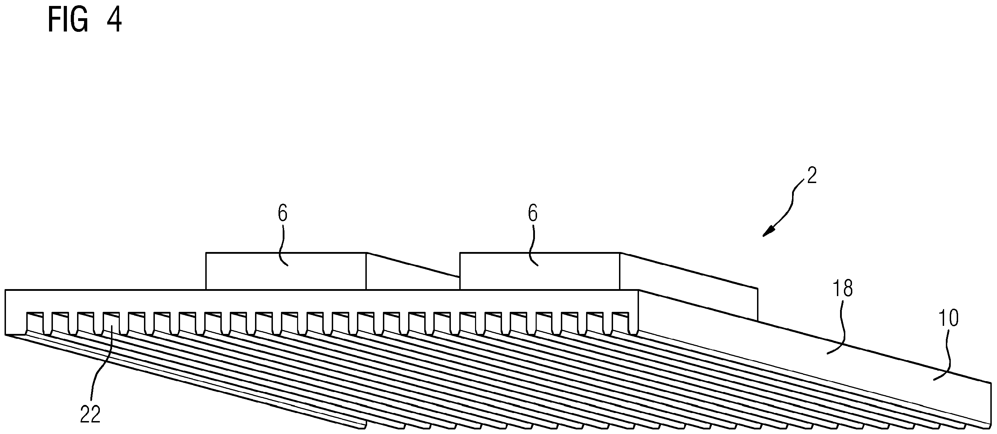

FIG 4 zeigt eine schematische dreidimensionale Darstellung eines Ausschnitts der ersten Ausgestaltung der Halbleitermodulanordnung 2, wobei das Mittelstück 18 des Kühlkörperaufsatzes 10 gezeigt ist, auf welchem die beispielhaft zwei Halbleitermodule 6 kontaktiert sind. Ferner sind die im Wesentlichen parallel angeordnete Kanäle 22 des Kühlkörperaufsatzes 10 zu sehen, welche einen, insbesondere identischen, rechteckigen Querschnitt aufweisen. Die weitere Ausgestaltung der Halbleitermodulanordnung 2 in FIG 4 entspricht der in FIG 1.

FIG 5 zeigt eine schematische Darstellung einer vierten Ausgestaltung, die nicht unter den Anspruchsgegenstand fällt, einer Halbleitermodulanordnung 2 im Querschnitt, wobei der Kühlkörperaufsatz 10 einstückig ausgebildet ist. Der einstückig ausgebildete Kühlkörperaufsatz 10 beispielsweise aus Aluminium oder einer Aluminiumlegierung, insbesondere mittels eines Gießverfahrens, hergestellt und stoffschlüssig mit dem Kühlkörpergrundkörper 8 verbunden, wobei die Kanalstruktur 14 durch die stoffschlüssige Verbindung hermetisch verschlossen ist. Die stoffschlüssige Verbindung wird beispielsweise durch Löten, Schweißen oder Sintern hergestellt.

Alternativ ist der einstückig ausgebildete Kühlkörperaufsatz 10 aus einem dielektrischen Werkstoff, insbesondere mittels eines Gießverfahrens, hergestellt und durch Adhäsion stoffschlüssig mit dem Kühlkörpergrundkörper 8 verbunden, wobei die Kanalstruktur 14 durch die adhäsive Verbindung hermetisch verschlossen ist. Ein dielektrischer Werkstoff ist beispielsweise ein keramischer Werkstoff wie Aluminiumoxid oder ein, insbesondere thermisch leitfähiger, Kunststoff. Das Halbleitermodul 6 ist in diesem Fall, insbesondere mit einem thermisch leitfähigen Kleber, auf dem Kühlkörperaufsatz 10 aufgeklebt. Optional ist der einstückig ausgebildete und aus einem dielektrischen Werkstoff hergestellte Kühlkörperaufsatz 10, insbesondere vollständig, mit einem metallischen Werkstoff beschichtet und beispielsweise durch Löten mit dem Kühlkörpergrundkörper 8 verbunden. Das Halbleitermodul 6 kann in diesem Fall ebenfalls auf dem Kühlkörperaufsatz 10 aufgeklebt, gesintert oder gelötet sein. Die weitere Ausgestaltung der Halbleitermodulanordnung 2 in FIG 5 entspricht der in FIG 2.

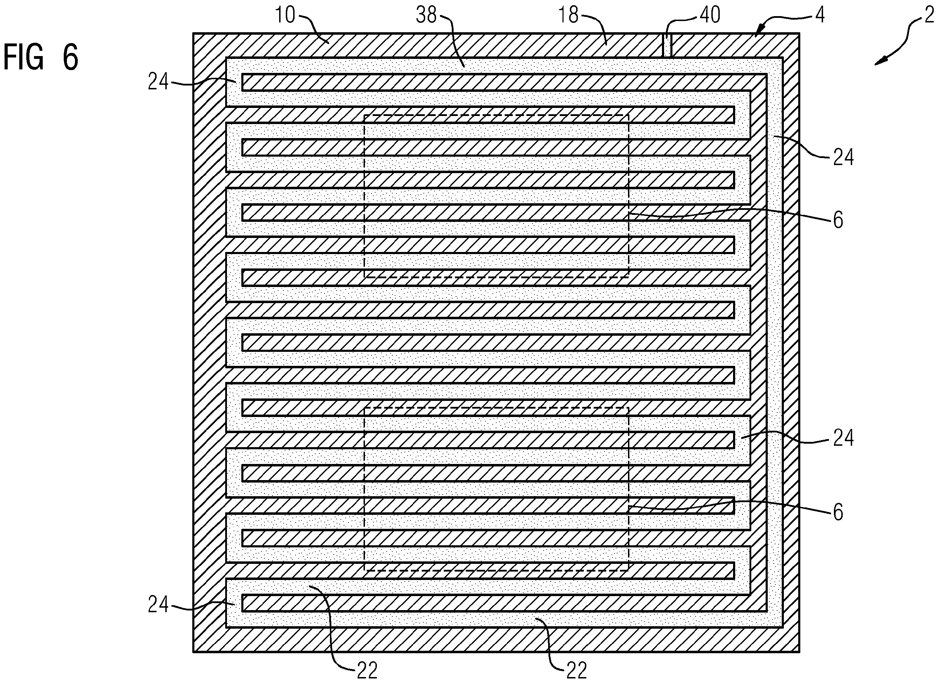

FIG 6 zeigt eine schematische Darstellung der vierten Ausgestaltung, die nicht unter den Anspruchsgegenstand fällt, der Halbleitermodulanordnung 2 im Längsschnitt. Die Kanalstruktur 14 des einstückig ausgebildeten Kühlkörperaufsatzes 10 weist einen mäanderförmigen Teil auf, wobei die Mäanderform durch die im Wesentlichen parallel angeordneten Kanäle 22 und die diese verbindenden Umlenkkanäle 24 ausgebildet wird. Eine verschließbare Öffnung 40 ist für eine Zuführung des Wärmetransportfluids 38 vorgesehen. Die weitere Ausgestaltung der Halbleitermodulanordnung 2 in FIG 6 entspricht der in FIG 5.

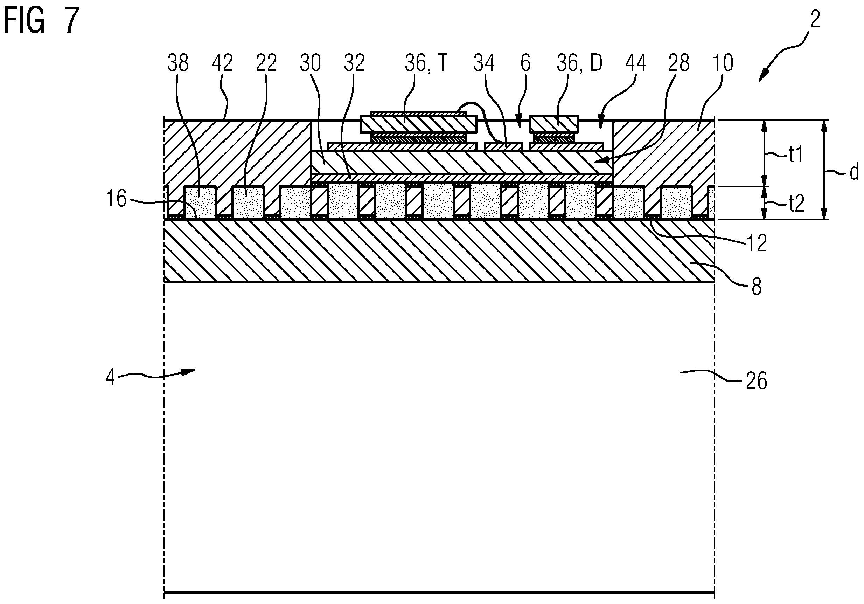

FIG 7 zeigt eine schematische Darstellung eines Ausschnitts einer fünften Ausgestaltung, die nicht unter den Anspruchsgegenstand fällt, einer Halbleitermodulanordnung im Querschnitt, wobei der Kühlkörperaufsatz 10 auf einer zweiten Oberfläche 42 eine Kavität 44 aufweist, in welcher das Halbleitermodul 6 mit dem Kühlkörperaufsatz 10 kontaktiert ist. Eine erste Tiefe t1 der Kavität 44, welche beispielsweise eine rechteckige Außenkontur aufweist, ist so dimensioniert, dass die Metallisierung 32 des Halbleitermoduls 6 in unmittelbarem Kontakt mit dem Wärmetransportfluid 38 steht. Ein unmittelbarer Kontakt besteht in diesem Zusammenhang, wenn das Wärmetransportfluid 38 direkt und ohne dazwischen angeordnete Komponenten mit Teilen der Metallisierung 32 des Halbleitermoduls 6 kontaktiert ist. Insbesondere addieren sich die erste Tiefe t1 der Kavität 44 und eine zweite Tiefe t2 der Kanäle 22 zu einer Dicke d des Kühlkörperaufsatzes 10. Die Kavität 44 ist beispielsweise durch Fräsen hergestellt. Das Halbleitermodul 6 ist stoffschlüssig, insbesondere durch Kleben oder Löten, mit dem Kühlkörperaufsatz 10 verbunden.

Durch die pulsierende Heatpipe ist eine gute Wärmeleitfähigkeit des die Kanalstruktur 14 umgebenden Materials nur zum Wärmeeintrag und Wärmeaustrag erforderlich. Ein Wärmeeintrag erfolgt über die Metallisierung 32 des Halbleitermoduls 6 und die Wärme wird an die Kühlkörpergrundkörperoberfläche 16 des Kühlkörpergrundkörpers 8 abgeben. Da die Strömung innerhalb der pulsierenden Heatpipe adiabat sein kann, kann der Kühlkörperaufsatz 10 aus einem Kunststoff mit einer geringen Wärmeleitfähigkeit gefertigt sein. Die weitere Ausgestaltung der Halbleitermodulanordnung 2 in FIG 7 entspricht der in FIG 2 oder FIG 5.

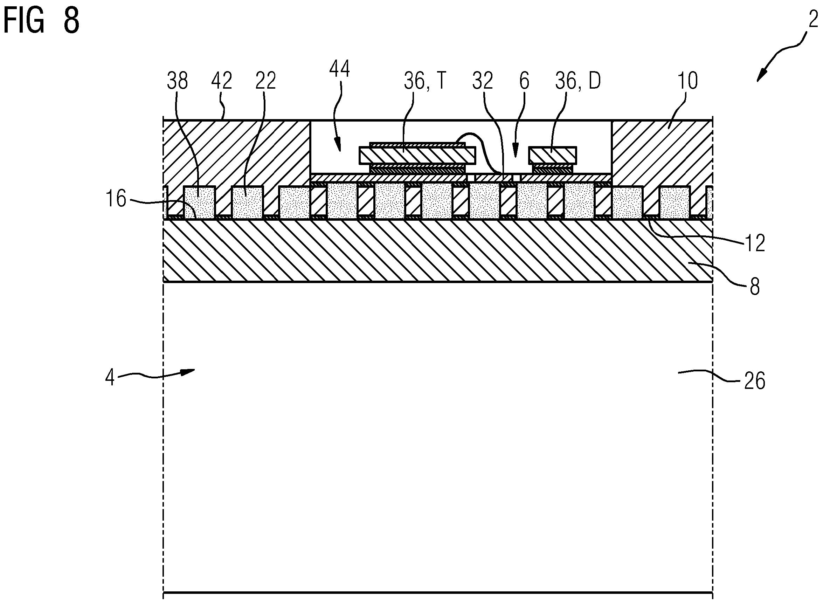

FIG 8 zeigt eine schematische Darstellung eines Ausschnitts einer sechsten Ausgestaltung, die nicht unter den Anspruchsgegenstand fällt, einer Halbleitermodulanordnung 2 im Querschnitt, wobei der Kühlkörperaufsatz 10 aus einem Kunststoff hergestellt ist. Das Halbleitermodul 6 umfasst Halbleiterbauelemente 36, die unmittelbar auf einer Metallisierung 32 kontaktiert sind. Unter einer unmittelbaren Kontaktierung ist in diesem Zusammenhang eine direkte Kontaktierung zu verstehen, die Verbindungsmittel wie Kleber, Lötzinn, Sinterpaste, ... zur Herstellung der Kontaktierung einschließt, ein zusätzliches Verbindungselement wie einen zusätzlichen Leiter, einen Abstandshalter, eine Bodenplatte, ... jedoch ausschließt. Die Metallisierung 32 des Halbleitermoduls 6 ist unmittelbar auf dem aus Kunststoff hergestellten Kühlkörperaufsatz 10 aufgeklebt. Die weitere Ausgestaltung der Halbleitermodulanordnung 2 in FIG 8 entspricht der in FIG 7.

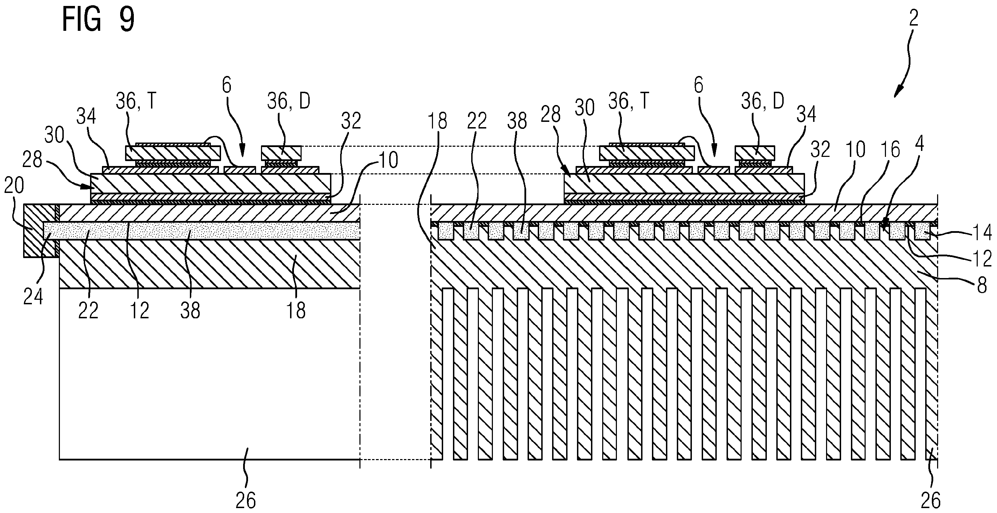

FIG 9 zeigt eine schematische Darstellung einer siebten Ausgestaltung einer Halbleitermodulanordnung 2 im Querschnitt. Der Kühlkörpergrundkörper 8 weist eine Kühlkörpergrundkörperoberfläche 16 auf, welche eine Kanalstruktur 14 umfasst, in der ein Wärmetransportfluid 38, beispielsweise Wasser, Aceton oder Methanol, angeordnet ist. Die Kanalstruktur 14 ist durch eine stoffschlüssige Verbindung des Kühlkörpergrundkörpers 8 mit einer ersten Oberfläche 12 des Kühlkörperaufsatzes 10 hermetisch verschlossen, sodass sowohl der Kühlkörperaufsatz 10 als auch der Kühlkörpergrundkörper 8 in unmittelbarem Kontakt mit dem Wärmetransportfluid 38 stehen und wobei durch die hermetisch verschlossene Kanalstruktur 14 und das Wärmetransportfluid 38 eine pulsierende Heatpipe ausgebildet ist, welche mit dem Halbleitermodul 6 in einer thermisch leitfähigen Verbindung steht.

Der Kühlkörpergrundkörper 8 weist ein Mittelstück 18 und beidseitig angeordnete Endstücke 20 auf, wobei das Mittelstück 18 im Wesentlichen parallel angeordnete Kanäle 22 der Kanalstruktur 14 umfasst und wobei die beidseitig angeordneten Endstücke 20 jeweils Umlenkkanäle 24 der Kanalstruktur 14 aufweisen, wobei die Umlenkkanäle 24 derartig angeordnet sind, dass die im Wesentlichen parallel angeordneten Kanäle 22 des Mittelstücks 18 in einer fluidtechnischen Verbindung stehen. Der Kühlkörpergrundkörper 8 weist auf einer dem Kühlkörperaufsatz 10 abgewandten Seite eine Mehrzahl von Kühlfinnen 26 auf, wobei die im Wesentlichen parallel angeordnete Kanäle 22 des Mittelstücks 18 parallel zu den Kühlfinnen 26 verlaufend angeordnet sind. Der Kühlkörpergrundkörper 8, welcher beispielsweise aus Aluminium oder einer Aluminiumlegierung hergestellt ist, ist so einfach mittels Strangpressen formbar. Die weitere Ausgestaltung der Halbleitermodulanordnung 2 in FIG 9 entspricht der in FIG 2.

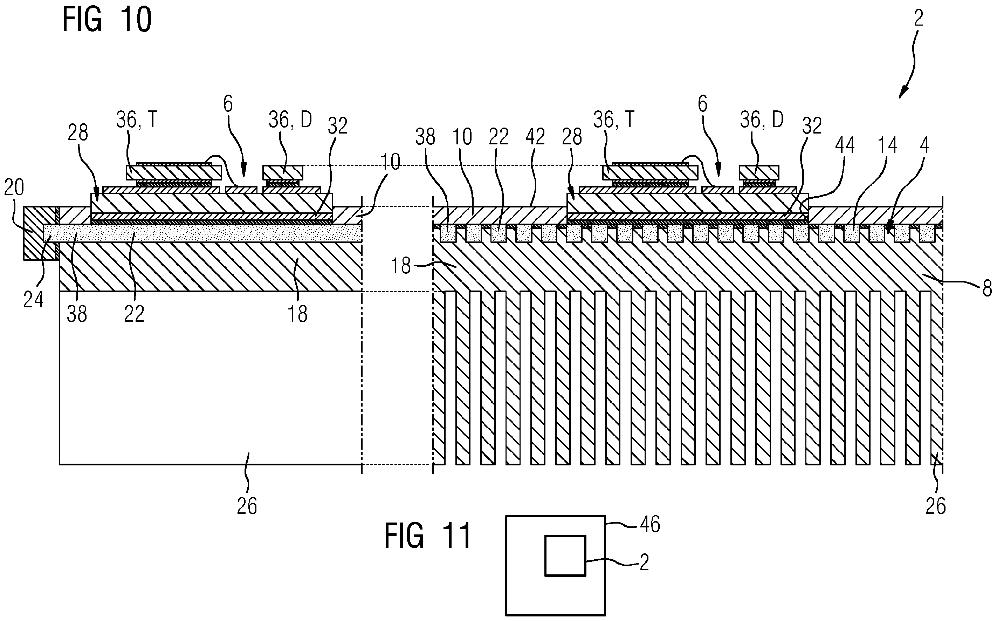

FIG 10 zeigt eine schematische Darstellung einer achten Ausgestaltung einer Halbleitermodulanordnung 2 im Querschnitt, wobei der Kühlkörperaufsatz 10 auf einer zweiten Oberfläche 42 eine durchgängige Kavität 44 aufweist, in welcher das Halbleitermodul 6 mit dem Kühlkörpergrundkörper 8 kontaktiert ist. Insbesondere ist die Metallisierung 32 des Substrats 28 stoffschlüssig mit dem Kühlkörpergrundkörper 8 verbunden, sodass das Halbleitermodul 6 in unmittelbarem Kontakt mit dem Wärmetransportfluid 38 steht. Die weitere Ausgestaltung der Halbleitermodulanordnung 2 in FIG 10 entspricht der in FIG 9.

FIG 11 zeigt eine schematische Darstellung eines Stromrichters 46 mit einer Halbleitermodulanordnung 2. Der Stromrichter 46 kann mehr als ein Halbleitermodulanordnung 2 umfassen.

Zusammenfassend betrifft die Erfindung eine Halbleitermodulanordnung 2 aufweisend einen Kühlkörper 4 und zumindest ein Halbleitermodul 6, welches auf dem Kühlkörper 4 kontaktiert ist. Um, im Vergleich zum Stand der Technik, eine effektivere Entwärmung und eine kostengünstigere Herstellung zu ermöglichen, wird vorgeschlagen, dass der Kühlkörper 4 einen Kühlkörpergrundkörper 8 und einen Kühlkörperaufsatz 10 umfasst, wobei der Kühlkörperaufsatz 10 auf einer ersten Oberfläche 12 eine Kanalstruktur 14 aufweist, in welcher ein Wärmetransportfluid 38 angeordnet ist, wobei der Kühlkörpergrundkörper 8 eine Kühlkörpergrundkörperoberfläche 16 aufweist, wobei die Kanalstruktur 14 durch eine stoffschlüssige Verbindung mit der Kühlkörpergrundkörperoberfläche 16 des Kühlkörpergrundkörpers 8 hermetisch verschlossen ist, sodass sowohl der Kühlkörperaufsatz 10 als auch der Kühlkörpergrundkörper 8 in unmittelbarem Kontakt mit dem Wärmetransportfluid 38 stehen, wobei durch die hermetisch verschlossene Kanalstruktur 14 und das Wärmetransportfluid 38 eine pulsierende Heatpipe ausgebildet ist, welche mit dem Halbleitermodul 6 in einer thermisch leitfähigen Verbindung steht.

## Patentansprüche

1. Halbleitermodulanordnung (2) aufweisend einen Kühlkörper (4) und zumindest ein Halbleitermodul (6), welches auf dem Kühlkörper (4) kontaktiert ist,
wobei der Kühlkörper (4) einen Kühlkörpergrundkörper (8) und einen Kühlkörperaufsatz (10) umfasst,
wobei der Kühlkörperaufsatz (10) auf einer ersten Oberfläche (12) eine Kanalstruktur (14) aufweist, in welcher ein Wärmetransportfluid (38) angeordnet ist,
wobei der Kühlkörpergrundkörper (8) eine Kühlkörpergrundkörperoberfläche (16) aufweist,
wobei die Kanalstruktur (14) durch eine stoffschlüssige Verbindung mit der Kühlkörpergrundkörperoberfläche (16) des Kühlkörpergrundkörpers (8) hermetisch verschlossen ist, sodass sowohl der Kühlkörperaufsatz (10) als auch der Kühlkörpergrundkörper (8) in unmittelbarem Kontakt mit dem Wärmetransportfluid (38) stehen,
wobei durch die hermetisch verschlossene Kanalstruktur (14) und das Wärmetransportfluid (38) eine pulsierende Heatpipe ausgebildet ist, welche mit dem Halbleitermodul (6) in einer thermisch leitfähigen Verbindung steht,
wobei der Kühlkörperaufsatz (10) ein Mittelstück (18) und beidseitig angeordnete Endstücke (20) aufweist,
wobei das Mittelstück (18) im Wesentlichen parallel angeordnete Kanäle (22) der Kanalstruktur (14) umfasst und
wobei die beidseitig angeordneten Endstücke (20) jeweils Umlenkkanäle (24) der Kanalstruktur (14) aufweisen,
wobei die Umlenkkanäle (24) derartig angeordnet sind, dass diese eine fluidtechnische Verbindung zwischen den im Wesentlichen parallel angeordneten Kanälen (22) des Mittelstücks (18) herstellen.

2. Halbleitermodulanordnung (2) nach Anspruch 1,
wobei der Kühlkörpergrundkörper (8) auf einer dem Kühlkörperaufsatz (10) abgewandten Seite eine Mehrzahl von Kühlfinnen (26) aufweist,
wobei die im Wesentlichen parallel angeordnete Kanäle (22) des Mittelstücks (18) quer zu den Kühlfinnen (26) verlaufend angeordnet sind.

3. Halbleitermodulanordnung (2) nach einem der vorherigen Ansprüche,
wobei das zumindest eine Halbleitermodul (6) ein Substrat (28) umfasst,
welches zumindest ein Halbleiterbauelement (36) und eine auf einer dem Halbleiterbauelement (36) abgewandten Seite angeordnete Metallisierung (32) umfasst,
wobei die Metallisierung (32) des Substrats (28) unmittelbar mit dem Kühlkörperaufsatz (10) verbunden ist.

4. Halbleitermodulanordnung (2) nach einem der vorherigen Ansprüche,
wobei der Kühlkörperaufsatz (10) auf einer zweiten Oberfläche (42) eine Kavität (44) aufweist, in welcher das Halbleitermodul (6) mit dem Kühlkörperaufsatz (10) kontaktiert ist.

5. Halbleitermodulanordnung (2) nach Anspruch 4,
wobei die Kavität (44) derartig ausgeführt ist, dass das Halbleitermodul (6) in unmittelbarem Kontakt mit dem Wärmetransportfluid (38) steht.

6. Halbleitermodulanordnung (2) nach einem der vorherigen Ansprüche,
wobei zumindest das Mittelstück (18) des Kühlkörperaufsatzes (10) aus einem metallischen Werkstoff, insbesondere aus Aluminium oder einer Aluminiumlegierung, hergestellt ist.

7. Halbleitermodulanordnung (2) nach Anspruch 6,
wobei das Mittelstück (18) des Kühlkörperaufsatzes (10) mittels Strangpressen, hergestellt ist.

8. Halbleitermodulanordnung (2) nach einem der Ansprüche 1 bis 5,
wobei der Kühlkörperaufsatz (10) aus einem dielektrischen Werkstoff hergestellt ist, welcher, insbesondere vollständig, mit einem metallischen Werkstoff beschichtet ist,
wobei das Halbleitermodul (6) durch Löten mit dem Kühlkörperaufsatz (10) verbunden ist.

9. Halbleitermodulanordnung (2) nach einem der Ansprüche 1 bis 5,
wobei der Kühlkörperaufsatz (10) aus einem dielektrischen Werkstoff hergestellt ist,
wobei das Halbleitermodul (6) durch Kleben mit dem Kühlkörperaufsatz (10) verbunden ist.

10. Halbleitermodulanordnung (2) nach Anspruch 8,
wobei das zumindest eine Halbleiterbauelement (36) des Halbleitermoduls (6) unmittelbar auf einer Metallisierung (32) kontaktiert ist,
wobei der dielektrische Werkstoff elektrisch isolierend ausgeführt ist,
wobei die Metallisierung (32) des Halbleitermoduls (6) unmittelbar auf dem aus einem dielektrischen Werkstoff hergestellten Kühlkörperaufsatz (10) aufgeklebt ist.

11. Halbleitermodulanordnung (2) nach einem der vorherigen Ansprüche,
wobei der Kühlkörpergrundkörper (8) auf einer dem Kühlkörperaufsatz (10) abgewandten Seite eine Mehrzahl von Kühlfinnen (26) aufweist,
wobei die im Wesentlichen parallel angeordnete Kanäle (22) des Mittelstücks (18) quer zu den Kühlfinnen (26) verlaufend angeordnet sind.

12. Halbleitermodulanordnung (2) aufweisend einen Kühlkörper (4) und zumindest ein Halbleitermodul (6), welches auf dem Kühlkörper (4) kontaktiert ist,
wobei der Kühlkörper (4) einen Kühlkörpergrundkörper (8) und einen Kühlkörperaufsatz (10) umfasst,
wobei der Kühlkörpergrundkörper (8) eine Kühlkörpergrundkörperoberfläche (16) aufweist,
wobei auf der Kühlkörpergrundkörperoberfläche (16) eine Kanalstruktur (14), in welcher ein Wärmetransportfluid (38) angeordnet ist, ausgebildet ist,
wobei der Kühlkörperaufsatz (10) eine erste Oberfläche (12) aufweist,
wobei die Kanalstruktur (14) durch eine stoffschlüssige Verbindung mit der ersten Oberfläche (12) des Kühlkörperaufsatzes (10) hermetisch verschlossen ist, sodass sowohl der Kühlkörperaufsatz (10) als auch der Kühlkörpergrundkörper (8) in unmittelbarem Kontakt mit dem Wärmetransportfluid (38) stehen,
wobei durch die hermetisch verschlossene Kanalstruktur (14) und das Wärmetransportfluid (38) eine pulsierende Heatpipe ausgebildet ist, welche mit dem Halbleitermodul (6) in einer thermisch leitfähigen Verbindung steht,
wobei der Kühlkörpergrundkörper (8) ein Mittelstück (18) und beidseitig angeordnete Endstücke (20) aufweist,
wobei das Mittelstück (18) im Wesentlichen parallel angeordnete Kanäle (22) der Kanalstruktur (14) umfasst und
wobei die beidseitig angeordneten Endstücke (20) jeweils Umlenkkanäle (24) der Kanalstruktur (14) aufweisen,
wobei die Umlenkkanäle (24) derartig angeordnet sind, dass die im Wesentlichen parallel angeordneten Kanäle (22) des Mittelstücks (18) in einer fluidtechnischen Verbindung stehen.

13. Halbleitermodulanordnung (2) nach Anspruch 12,
wobei das zumindest eine Halbleitermodul (6) ein Substrat (28) umfasst,
welches zumindest ein Halbleiterbauelement (36) und eine auf einer dem Halbleiterbauelement (36) abgewandten Seite angeordnete Metallisierung (32) umfasst,
wobei die Metallisierung (32) des Substrats (28) unmittelbar mit dem Kühlkörper (4) verbunden ist.

14. Halbleitermodulanordnung (2) nach einem der Ansprüche 12 bis 13,
wobei der Kühlkörperaufsatz (10) auf einer zweiten Oberfläche (42) eine durchgängige Kavität (44) aufweist, in welcher das Halbleitermodul (6) mit dem Kühlkörpergrundkörper (8) kontaktiert ist, sodass das Halbleitermodul (6) in unmittelbarem Kontakt mit dem Wärmetransportfluid (38) steht.

15. Halbleitermodulanordnung (2) nach einem der Ansprüche 12 bis 14,
wobei zumindest das Mittelstück (18) des Kühlkörpergrundkörpers (8) aus einem metallischen Werkstoff, insbesondere aus Aluminium oder einer Aluminiumlegierung, hergestellt ist.

16. Halbleitermodulanordnung (2) nach Anspruch 15,
wobei das Mittelstück (18) des des Kühlkörpergrundkörpers (8) mittels Strangpressen, hergestellt ist.

17. Halbleitermodulanordnung (2) nach einem der Ansprüche 12 bis 15,
wobei der Kühlkörpergrundkörper (8) auf einer dem Kühlkörperaufsatz (10) abgewandten Seite eine Mehrzahl von Kühlfinnen (26) aufweist,
wobei die im Wesentlichen parallel angeordnete Kanäle (22) des Mittelstücks (18) parallel zu den Kühlfinnen (26) verlaufend angeordnet sind.

18. Stromrichter (46) mit mindestens einer Halbleitermodulanordnung (2) nach einem der vorherigen Ansprüche.

## Claims

1. Semiconductor module assembly (2) having a cooling body (4) and at least one semiconductor module (6) which is contacted on the cooling body (4),
wherein the cooling body (4) comprises a cooling body main body (8) and a cooling body attachment (10),
wherein the cooling body attachment (10) has, on a first surface (12), a channel structure (14) in which a heat-transporting fluid (38) is arranged,
wherein the cooling body main body (8) has a cooling body main body surface (16),
wherein the channel structure (14) is hermetically sealed by an integral connection with the cooling body main body surface (16) of the cooling body main body (8) so that both the cooling body attachment (10) and the cooling body main body (8) are in direct contact with the heat-transporting fluid (38),
wherein the hermetically sealed channel structure (14) and the heat-transporting fluid (38) form a pulsating heat pipe which is thermally conductively connected to the semiconductor module (6),
wherein the cooling body attachment (10) has a central piece (18) and end pieces (20) arranged on both sides,
wherein the central piece (18) comprises essentially parallel channels (22) of the channel structure (14) and
wherein the end pieces (20) arranged on both sides each have deflection channels (24) of the channel structure (14),
wherein the deflection channels (24) are arranged in such a way that they establish a fluidic connection between the essentially parallel channels (22) of the central piece (18).

2. Semiconductor module assembly (2) according to claim 1,
wherein the cooling body main body (8) has a plurality of cooling fins (26) on a side facing away from the cooling body attachment (10),
wherein the essentially parallel channels (22) of the central piece (18) are arranged running transversely to the cooling fins (26).

3. Semiconductor module assembly (2) according to one of the preceding claims,
wherein the at least one semiconductor module (6) comprises a substrate (28),
which comprises at least one semiconductor element (36) and a metallisation (32) arranged on the side facing away from the semiconductor element (36),
wherein the metallisation (32) of the substrate (28) is directly connected to the cooling body attachment (10).

4. Semiconductor module assembly (2) according to one of the preceding claims,
wherein the cooling body attachment (10) has a cavity (44) on a second surface (42), in which the semiconductor module (6) is contacted with the cooling body attachment (10).

5. Semiconductor module assembly (2) according to claim 4,
wherein the cavity (44) is designed in such a way that the semiconductor module (6) is in direct contact with the heat-transporting fluid (38).

6. Semiconductor module assembly (2) according to one of the preceding claims,
wherein at least the central piece (18) of the cooling body attachment (10) is made from a metallic material, in particular from aluminium or an aluminium alloy.

7. Semiconductor module assembly (2) according to claim 6, wherein the central piece (18) of the cooling body attachment (10) is produced by means of extrusion.

8. Semiconductor module assembly (2) according to one of claims 1 to 5,
wherein the cooling body attachment (10) is made of a dielectric material, which is coated, in particular completely, with a metallic material,
wherein the semiconductor module (6) is connected to the cooling body attachment (10) by means of soldering.

9. Semiconductor module assembly (2) according to one of claims 1 to 5,
wherein the cooling body attachment (10) is made of a dielectric material,
wherein the semiconductor module (6) is connected to the cooling body attachment (10) by means of adhesive bonding.

10. Semiconductor module assembly (2) according to claim 8,
wherein the at least one semiconductor element (36) of the semiconductor module (6) is contacted directly on a metallisation (32),
wherein the dielectric material is designed to be electrically insulating,
wherein the metallisation (32) of the semiconductor module (6) is adhesively bonded directly to the cooling body attachment (10) made of a dielectric material.

11. Semiconductor module assembly (2) according to one of the preceding claims,
wherein the cooling body main body (8) has a plurality of cooling fins (26) on a side facing away from the cooling body attachment (10),
wherein the essentially parallel channels (22) of the central piece (18) are arranged running transversely to the cooling fins (26).

12. Semiconductor module assembly (2) having a cooling body (4) and at least one semiconductor module (6) which is contacted on the cooling body (4),
wherein the cooling body (4) comprises a cooling body main body (8) and a cooling body attachment (10),
wherein the cooling body main body (8) has a cooling body main body surface (16),
wherein a channel structure (14), in which a heat-transporting fluid (38) is arranged, is formed on the cooling body main body surface (16),
wherein the cooling body attachment (10) has a first surface (12),
wherein the channel structure (14) is hermetically sealed to the first surface (12) of the cooling body attachment (10) by an integral connection, so that both the cooling body attachment (10) and the cooling body main body (8) are in direct contact with the heat-transporting fluid (38),
wherein the hermetically sealed channel structure (14) and the heat-transporting fluid (38) form a pulsating heat pipe which is thermally conductively connected to the semiconductor module (6),
wherein the cooling body main body (8) has a central piece (18) and end pieces (20) arranged on both sides,
wherein the central piece (18) comprises essentially parallel channels (22) of the channel structure (14) and
wherein the end pieces (20) arranged on both sides each have deflection channels (24) of the channel structure (14),
wherein the deflection channels (24) are arranged in such a way that the essentially parallel channels (22) of the central piece (18) are in fluidic connection.

13. Semiconductor module assembly (2) according to claim 12,
wherein the at least one semiconductor module (6) comprises a substrate (28),
which comprises at least one semiconductor element (36) and a metallisation (32) on the side facing away from the semiconductor element (36),
wherein the metallisation (32) of the substrate (28) is directly connected to the cooling body (4).

14. Semiconductor module assembly (2) according to one of claims 12 to 13,
wherein the cooling body attachment (10) has a continuous cavity (44) on a second surface (42), in which the semiconductor module (6) is contacted with the cooling body main body (8), so that the semiconductor module (6) is in direct contact with the heat-transporting fluid (38).

15. Semiconductor module assembly (2) according to one of claims 12 to 14,
wherein at least the central piece (18) of the cooling body main body (8) is made of a metallic material, in particular of aluminium or an aluminium alloy.

16. Semiconductor module assembly (2) according to claim 15, wherein the central piece (18) of the cooling body main body (8) is produced by means of extrusion.

17. Semiconductor module assembly (2) according to one of claims 12 to 15,
wherein the cooling body main body (8) has a plurality of cooling fins (26) on a side facing away from the cooling body attachment (10),
wherein the essentially parallel channels (22) of the central piece (18) are arranged running parallel to the cooling fins (26).

18. Power converter (46) with at least one semiconductor module assembly (2) according to one of the preceding claims.

## Revendications

1. Agencement (2) de module à semiconducteur comportant un puits (4) de chaleur et au moins un module (6) à semiconducteur, qui est en contact sur le puits (4) de chaleur,
dans lequel le puits (4) de chaleur comprend un corps (8) de base de puits de chaleur et un entablement (10) de puits de chaleur, dans lequel l'entablement (10) de puits de chaleur a, sur une première surface (12), une structure (14) en canal, dans laquelle un fluide (38) de transport de la chaleur est disposé,
dans lequel le corps (8) de base du puits de chaleur a une surface (16) de corps de base du puits de chaleur,
dans lequel la structure (14) en canal est fermée hermétiquement par une liaison à coopération de matière avec la surface (16) du corps (8) de base du puits de chaleur de sorte que tant l'entablement (10) du puits de chaleur qu'également le corps (8) de base du puits de chaleur soient en contact direct avec le fluide (38) de transport de chaleur,
dans lequel, par la structure (14) en canal fermée hermétiquement et le fluide (38) de transport de chaleur, il est constitué une heatpipe pulsée, qui est en liaison conductrice thermiquement avec le module (6) à semiconducteur,
dans lequel l'entablement (10) du puits de chaleur a une pièce (18) médiane et des pièces (20) d'extrémité disposées des deux côtés,
dans lequel la pièce (18) médiane comprend des canaux (22) de la structure (14) en canal disposés sensiblement parallèlement, et
dans lequel les pièces (20) d'extrémité disposées des deux côtés ont chacune des canaux (24) de renvoi de la structure (14) en canal,
dans lequel les canaux (24) de renvoi sont disposés de telle façon qu'ils donnent une communication en technique des fluides entre les canaux (22) de la pièce (18) médiane disposées sensiblement parallèlement.

2. Agencement (2) de module à semiconducteur suivant la revendication 1,
dans lequel le corps (8) de base du puits de chaleur a, d'un côté loin de l'entablement (10) du puits de chaleur, une pluralité d'ailettes (26) de refroidissement,
dans lequel les canaux (22) de la pièce (18) médiane disposés sensiblement parallèlement s'étendent transversalement aux ailettes (26) de refroidissement.

3. Agencement (2) de module à semiconducteur suivant l'une des revendications précédentes,
dans lequel le au moins un module (6) à semiconducteur comprend un substrat (28),
lequel comprend au moins un composant (36) à semiconducteur et une métallisation (32) disposée d'un côté loin du composant (36) à semiconducteur,
dans lequel la métallisation (32) du substrat (28) est reliée directement à l'entablement (10) du puits de chaleur.

4. Agencement (2) de module à semiconducteur suivant l'une des revendications précédentes,
dans lequel l'entablement (10) du puits de chaleur a, sur une deuxième surface (42), une cavité (44), dans laquelle le module (6) à semiconducteur est en contact avec l'entablement (10) du puits de chaleur.

5. Agencement (2) de module à semiconducteur suivant la revendication 4,
dans lequel la cavité (44) est réalisée de telle façon que le module (6) à semiconducteur est en contact direct avec le fluide (38) de transport de la chaleur.

6. Agencement (2) de module à semiconducteur suivant l'une des revendications précédentes,
dans lequel au moins la pièce (18) médiane de l'entablement (10) du puits de chaleur est en un matériau métallique, en particulier en aluminium ou en un alliage d'aluminium.

7. Agencement (2) de module à semiconducteur suivant la revendication 6,
dans lequel la pièce (18) médiane de l'entablement (10) du puits de chaleur est fabriquée au moyen d'un filage à la presse.

8. Agencement (2) de module à semiconducteur suivant l'une des revendications 1 à 5,
dans lequel l'entablement (10) du puits de chaleur est en un matériau diélectrique, qui est revêtu, en particulier complètement, d'un matériau métallique,
dans lequel le module (6) à semiconducteur est relié par brasure à l'entablement (10) du puits de chaleur.

9. Agencement (2) de module à semiconducteur suivant l'une des revendications 1 à 5,
dans lequel l'entablement (10) du puits de chaleur est en un matériau diélectrique,
dans lequel le module (6) à semiconducteur est relié par collage à l'entablement (10) du puits de chaleur.

10. Agencement (2) de module à semiconducteur suivant la revendication 8,
dans lequel le au moins un composant (36) à semiconducteur du module (6) à semiconducteur est en contact direct sur une métallisation (32),
dans lequel le matériau diélectrique est réalisé de manière isolante électrique,
dans lequel la métallisation (32) du module (6) à semiconducteur est collée directement sur l'entablement (10) du puits de chaleur en un matériau diélectrique.

11. Agencement (2) de module à semiconducteur suivant l'une des revendications précédentes,
dans lequel le corps (8) de base du puits de chaleur a, d'un côté loin de l'entablement (10) du puits de chaleur, une pluralité d'ailettes (26) de refroidissement,
dans lequel les canaux (22) de la pièce (18) médiane disposés sensiblement parallèlement s'étendent transversalement aux ailettes (26) de refroidissement.

12. Agencement (2) de module à semiconducteur comportant un puits (4) de chaleur et au moins un module (6) à semiconducteur, qui est en contact sur le puits (4) de chaleur,
dans lequel le puits (4) de chaleur comprend un corps (8) de base de puits de chaleur et un entablement (10) de puits de chaleur, dans lequel le corps (8) de base du puits de chaleur a une surface (16) de corps de base de puits de chaleur,
dans lequel il est constitué, sur la surface (16) de corps de base du puits de chaleur, une structure (14) en canal, dans laquelle est disposé un fluide (38) de transport de la chaleur,
dans lequel l'entablement (10) du puits de chaleur a une première surface (12),
dans lequel la structure (14) en canal est fermée hermétiquement par une liaison à coopération de matière avec la première surface (12) de l'entablement (10) du puits de chaleur de sorte que tant l'entablement (10) du puits de chaleur qu'également le corps (8) de base du puits de chaleur soient en contact direct avec le fluide (38) de transport de la chaleur,
dans lequel, par la structure (14) en canal fermée hermétiquement et par le fluide (38) de transport de la chaleur, il est constitué une heatpipe pulsée, qui est en liaison conductrice thermiquement avec le module (6) à semiconducteur,
dans lequel le corps (8) de base du puits de chaleur a une pièce (18) médiane et des pièces (20) disposées des deux côtés,
dans lequel la pièce (18) médiane comprend des canaux (22) de la structure (14) en canal disposés sensiblement parallèlement, et
dans lequel les deux pièces (20) d'extrémité disposées des deux côtés ont chacune des canaux (24) de renvoi de la structure (14) en canal,
dans lequel les canaux (24) de renvoi sont disposés de telle façon que les canaux (22) de la pièce (18) médiane disposés sensiblement parallèlement sont en communication en technique des fluides.

13. Agencement (2) de module à semiconducteur suivant la revendication 12,
dans lequel le au moins un module (6) à semiconducteur comprend un substrat (28),
qui comprend au moins un composant (36) à semiconducteur et une métallisation (32) disposée d'un côté loin du composant (36) à semiconducteur,
dans lequel la métallisation (32) du substrat (28) est reliée directement au puits (4) de chaleur.

14. Agencement (2) de module à semiconducteur suivant l'une des revendications 12 à 13,
dans lequel l'entablement (10) du puits de chaleur a, sur une deuxième surface (42), une cavité (44) traversante, dans laquelle le module (6) à semiconducteur est en contact avec le corps (8) de base du puits de chaleur, de sorte que le module (6) à semiconducteur soit en contact direct avec le fluide (38) de transport de la chaleur.

15. Agencement (2) de module à semiconducteur suivant l'une des revendications 12 à 14,
dans lequel au moins la pièce (18) médiane du corps (8) de base du puits de chaleur est en un matériau métallique, en particulier en aluminium ou en un alliage d'aluminium.

16. Agencement (2) de module à semiconducteur suivant la revendication 15,
dans lequel la pièce (18) médiane du corps (8) de base du puits de chaleur est fabriquée au moyen d'un filage à la presse.

17. Agencement (2) de module à semiconducteur suivant l'une des revendications 12 à 15,
dans lequel le corps (8) de base du puits de chaleur a, d'un côté loin de l'entablement (10) du puits de chaleur, une pluralité d'ailettes (26) de refroidissement,
dans lequel les canaux (22) de la pièce (18) médiane disposés sensiblement parallèlement s'étendent parallèlement aux ailettes (26) de refroidissement.

18. Convertisseur (46) ayant au moins un agencement (2) de module à semiconducteur suivant l'une des revendications précédentes.
